Europäisches Patentamt

European Patent Office

Office européen des brevets

(19)

(11) Publication number: **0 152 669**
**A2**

(12) **EUROPEAN PATENT APPLICATION**

(21) Application number: **84304413.2**

(22) Date of filing: **28.06.84**

(51) Int. Cl.⁴: **C 23 C 16/44,** C 23 C 14/34, C 23 C 14/24

(30) Priority: **17.02.84 US 581102**

(43) Date of publication of application: **28.08.85**
**Bulletin 85/35**

(84) Designated Contracting States: **AT BE CH DE FR GB IT LI LU NL SE**

(71) Applicant: **STAUFFER CHEMICAL COMPANY, Westport Connecticut 06881 (US)**

(72) Inventor: **Gersten, Susan Wendy, 1504 Old Country Road, Elmsford, N.Y. 10523 (US)**
Inventor: **Kuck, Mark Allen, 445 Warfield Street, Upper Montclair, N.J. 07043 (US)**

(74) Representative: **Smith, Sydney et al, Elkington and Fife High Holborn House 52/54 High Holborn, London WC1V 6SH (GB)**

(54) Continuous pnictide source and delivery system for film deposition, particularly by chemical vapour deposition.

(57) A film deposition apparatus characterised in that it comprises:

(A) a reservoir for containing pnictide;
(B) means for passing an inert gas therethrough;
(C) a film desposition reaction chamber; and
(D) means for supplying inert gas carrying vapour species after passing through the said pnictide to the said reaction chamber.

A process for the supply of a pnictide vapour species to a film deposition process characterised in that it comprises passing an inert gas through a reservoir of heated pnictide.

Referring to the accompanying illustrative diagram, there may be identified reservoir (30), means (B) may comprise tube (28), a chamber (C) is indicated at (22) and means (D) may comprise tube (60).

Such a pnictide bubbler feed system may be used to supply Pnictide₄ species for various film deposition processes, including chemical vapour deposition, sputtering, vacuum deposition and molecular beam epitazy. Films of pnictide, polypnictide and other pnictide compounds may be deposited for semiconductor and other applications including insulation and passivation. The pnictides used may include phosphorus, arsenic and antimony.

The present invention represents an advance over the prior art.

ACTORUM AG

Continuous pnictide source and delivery system for film deposition, particularly by chemical vapour deposition

This invention relates to a continuous pnictide source and delivery system for film deposition, particularly by chemical vapour deposition; it also relates to sources of Pnictide$_4$ vapour species; to the deposition of films of pnictides, polypnictides and other pnictide compounds, particularly when the pnictide is phosphorus; to chemical vapour deposition, sputtering, vacuum deposition and molecular beam deposition; to semiconductor devices and to the insulation and passivation thereof.

For further information, reference may be made to, for example, GB-A- 2,113,663 and to the related applications filed herewith, in particular those based on USSN 581,104, USSN 581,139, USSN 509,157, USSN 509,175, USSN 581,115, USSN 509,158, USSN 581,103, USSN 581,105, USSN 581,102 and USSN 581,101.

Pnictide$_4$ vapour species, particularly $P_4$, is needed for use in various film deposition processes; for example, processes for the deposition of films of phosphorus, polyphosphides and other phosphorus compounds for use in semiconductor devices. These films may be deposited by chemical vapour deposition, sputtering, vacuum deposition and molecular beam deposition. It is highly desirable that a source of the Pnictide$_4$ vapour species be capable of delivering accurately metered amounts of the species into these processes. It is also highly desirable to be able continuously to supply the Pnictide$_4$ vapour species for an indefinite period of time for depositing films on large areas and for continuous processing.

It is therefore an object of the present invention to provide a Pnictide$_4$, particularly a $P_4$, source and

delivery system for film deposition.

Another object of the present invention is to provide such a continuous delivery system.

A further object of the present invention is to provide such a delivery system utilizing an inert carrier gas.

Yet another object of the present invention is to facilitate the deposition of the films of pnictides, polypnictides and other pnictide compounds, particularly when the pnictide is phosphorus, by chemical vapour deposition, sputtering vacuum deposition and molecular beam deposition.

The present invention provides a film deposition apparatus characterised in that it comprises:

(A) a reservoir for containing pnictide;

(B) means for passing an inert gas therethrough;

(C) a film deposition reaction chamber; and

(D) means for supplying inert gas carrying vapour species after passing through the said pnictide to the said reaction chamber.

Heating means are preferably provided for the reservoir, for example a surrounding heated liquid. The reservoir is generally a vertical tube with the inert gas, preferably argon, entering at the bottom, preferably via a gas distribution means, such as a porous frit. The reaction chamber is preferably a chemical vapour deposition chamber. Such apparatus may be paired in order to avoid interruption of pnictide supply on recharging.

The present invention also provides a process for the supply of a pnictide vapour species to a film deposition process characterised in that it comprises passing an inert gas through a reservoir of heated pnictide.

Further, the present process may comprise the deposition of the pnictide vapour species on a substrate.

The pnictide, preferably P, is generally maintained below its boiling point. The inert gas may be passed through the pnictide at a pressure of from 0.1 to 2.0 atmospheres (from $1.01 \times 10^4$ to $2.02 \times 10^5$ Pa). The Pnictide$_4$-containing inert gas may be produced at a pressure of from 0.1 to 1.0 atmospheres (from $1.01 \times 10^4$ to $1.01 \times 10^5$ Pa).

In more detail now, an inert carrier gas, such as argon, passes down a length of tubing and then upwardly through a sintered glass frit before passing through a vertical column of pnictide, such as white phosphorus. The pnictide-enriched carrier gas then exits through the top of the column and may be diluted by a stream of pure carrier gas. The mixture of the Pnictide$_4$ vapour species and the carrier gas is then fed into a reaction chamber after passing through a metering valve. The temperature of the pnictide reservoir is maintained constant by a circulating bath of oil or tube furnace heated to between the melting and boiling points of the pnictide, e.g. 44°C and 280°C, respectively, for phosphorus. The temperature of the downstream transfer lines is maintained by the use of heating tapes. The pressure in the feed system is controlled by the downstream metering valve.

Thus, the concentration of Pnictide$_4$ species fed into a reaction chamber may be controlled by regulating the flow of the carrier gas, the temperature of the pnictide in the reservoir and the pressure maintained in the feed system.

For a fuller understanding of the nature and objects of the present invention reference may be made to the accompanying illustrative drawings wherein:

Figure 1 is a diagram of a Pnictide$_4$ source for film deposition in a chemical vapour deposition process; and

Figure 2 is a diagram of a continuous Pnictide$_4$ source for film deposition.

The same reference numbers refer to the same elements throughout the several views of the drawings.

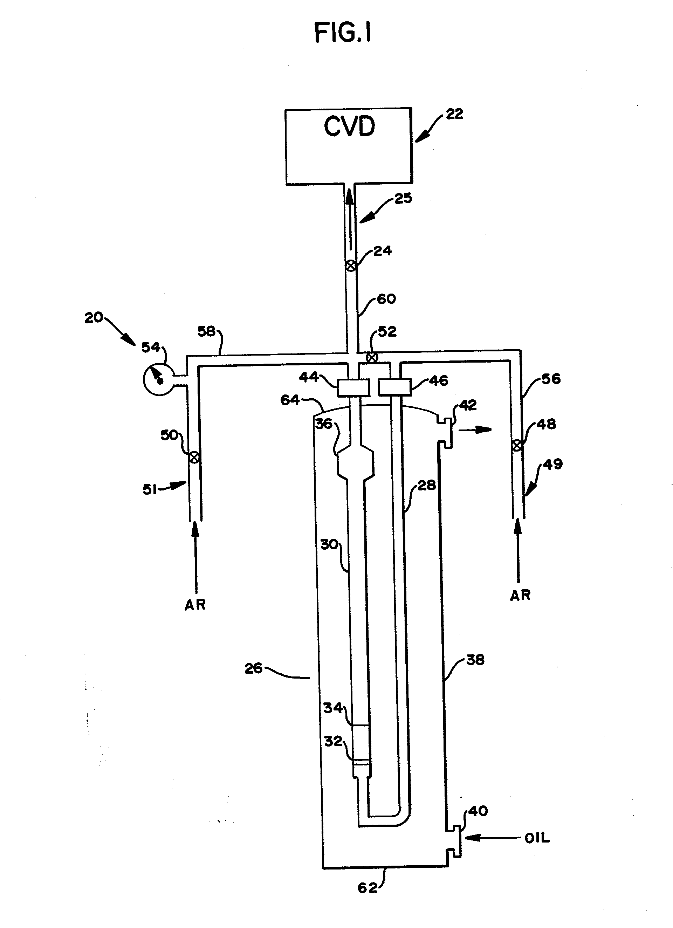

Referring to accompanying Figure 1, a pnictide source according to the present invention is generally indicated at 20. It is connected to supply Pnictide$_4$ species carried by an inert carrier gas to chemical vapour deposition (CVD) apparatus 22 through metering valve 24.

The pnictide source according to the present invention is generally indicated at 26. It comprises a vertical carrier gas feed tube 28 and vertical pnictide containing reservoir 30. A porous frit disc 32 is located at the bottom of the reservoir 30 to disperse the carrier gas stream which passes through the pnictide in the reservoir 30. In the case of phosphorus, for example, any bubbles forming above the top surface 34 of the liquid phosphorus are collected and break at the enlarged portion 36 of the reservoir 30.

The entire source apparatus is enclosed in vessel 38. Oil from a constant temperature bath is constantly circulated, entering at opening 40 and exiting at opening 42.

The source 26 may be conveniently attached to the system 20 via connectors 44 and 46. The source 26 may be disconnected from the oil bath by disconnecting appropriate connectors at 40 and 42. Thus, the entire source 26 and system 20 may be disconnected by connector (not shown) at 49, 51 and 25, and may be carried into a glove box purged with an inert gas, such as nitrogen, filled with pnictide, such as phosphorus, connected to the apparatus 20 and removed from the glove box with the valves 24, 48 and 50 closed. Inert carrier gas is supplied through a shutoff valve 48 to vertical tube 28 of the source 26. It passes through the pnictide contained therein. For example, additional argon diluent gas is supplied through a shutoff valve 50 and mixes with the argon carried pnictide species which is then supplied through the metering valve 24 to a chemical vapour deposition reaction chamber 22.

By-pass valve 52 is utilized initially to purge the system and to equalize the pressure on both sides of the source 26 before startup of the carrier gas flow through the reservoir 30. The pressure gauge 54 monitors the pressure of the carrier gas and pnictide species being supplied to the metering valve 24.

The temperature of the source 26 is maintained constant by the circulating oil and is maintained at a temperature above the melting point of the pnictide and below the boiling point of the pnictide. Typical flow rates through the metering valve 24 are from 10 to 200 millilitres per minute. Typical pressures of the carrier gas supplied, range from 0.1 to 2.0 atmospheres (from $1.01 \times 10^4$ to $2.02 \times 10^5$ Pa). The downstream pressures in line 60 range from 0.1 to 1.0 atmospheres (from $1.01 \times 10^4$ to $1.01 \times 10^5$ Pa).

From 6 to 10 millilitres of pnictide may be contained in the reservoir 30 which has a capacity of 30 millilitres, for example.

The source 26 may be made of Pyrex or stainless steel. The carrier gas supply tubing 56, diluent supply tubing 58 and downstream tubing 60 may be stainless steel.

Thin wall tube 28 may have an outside diameter of 0.2 centimetres. The reservoir, which is also thin-walled, may have an outside diameter of 1.5 centimetres. The entire source apparatus, from the bottom 62 of jacket 38 to the top 64 thereof, is 35 centimetres, for example. The enlarged portion 36 of the reservoir 30 may have an outside diameter of 2.5 centimetres.

All of the tubing that could come in contact with the Pnictide$_4$ vapour, that is, tubing 56, 58 and 60, is preferably surrounded by heating tape (not shown) and maintained at a temperature of about 20C° above that of the reservoir operating temperature to prevent the deposition of pnictide on the surface of the tubing.

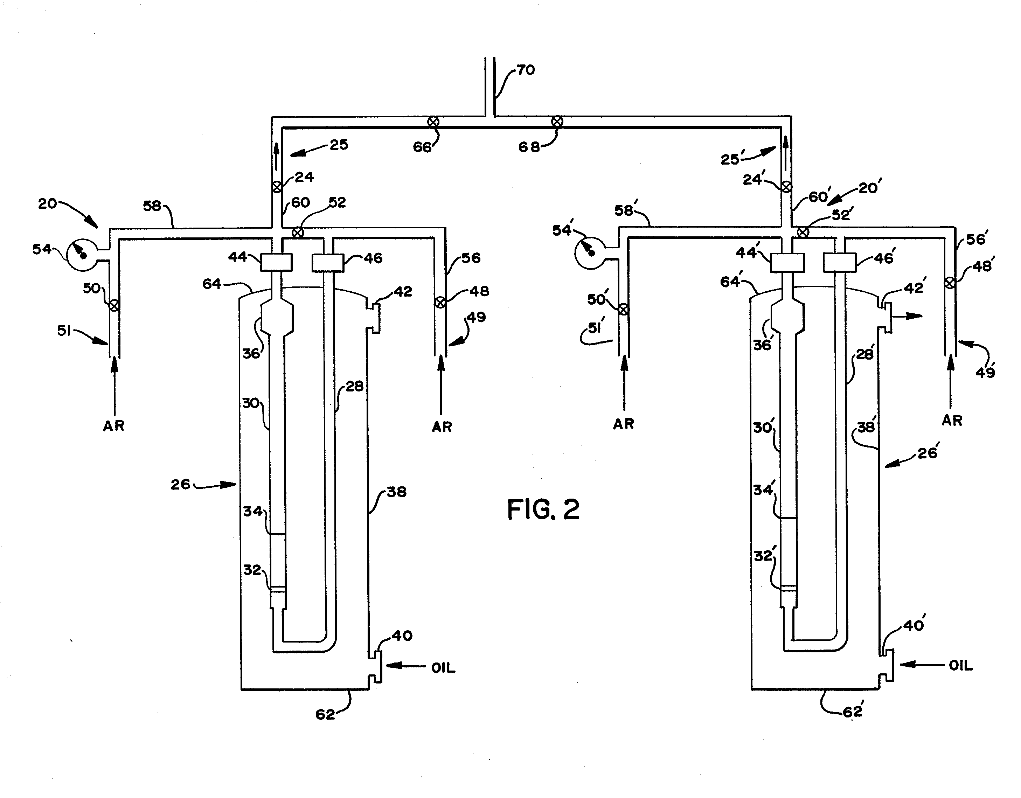

Referring to accompanying Figure 2, a continuous pnictide source comprises two pnictide source systems 20 and 20', identical to that illustrated in Figure 1, connected through a pair of shutoff valves 66 and 68 to a common downstream tube 70.

To begin a long term process, source 26 is connected via connectors 44 and 46, shutoff valve 66 is opened and the entire apparatus 20 is operated as described with reference to Figure 1. When the pnictide in the reservoir 30 is about to run out, shutoff valve 66 is closed and shutoff valve 68 is opened, source 26' having previously been filled and connected via valve connectors 44' and 46' to the apparatus 20'.

Thus, by alternating between the two systems 20 and 20', a continuous supply of the pnictide species carried by argon gas, for example, may be supplied through downstream tube 70.

The chemical vapour deposition reaction chamber 22 is preferably that disclosed in GB-A- 2,113,663 mentioned above.

While the pnictide source 20 is preferably used to supply $P_4$ species from the pnictide in reservoir 30, other pnictides, such as arsenic and antimony, may be used.

The white phosphorus utilized in the source 26 is preferably the product of the method of preparing high purity white phosphorus disclosed in the above-identified related application based on USSN 581,105.

In addition to being used to supply pnictides to a chemical vapour deposition apparatus as illustrated herein, the present pnictide source may be used to supply pnictide vapour species to low vacuum apparatus, such as a sputterer as disclosed in the related application based on USSN 581,103 and high vacuum apparatus, such as the vacuum deposition and molecular beam deposition apparatus disclosed in the related application based on USSN 581,104.

0152669

CLAIMS:

1.   A film deposition apparatus characterised in that it comprises:

(A) a reservoir (30) for containing pnictide;

(B) means (18) for passing an inert gas therethrough;

(C) a film deposition reaction chamber (22); and

(D) means (60) for supplying inert gas carrying vapour species after passing through the said pnictide to the said reaction chamber.

2.   An apparatus as claimed in claim 1 comprising:

(E) heating means (38) for the said reservoir.

3.   An apparatus as claimed in claim 2 wherein the said heating means comprises a heated liquid surrounding the said reservoir.

4.   An apparatus as claimed in any of claims 1 to 3 wherein the said reservoir is a vertical tube comprising an opening for admitting the said gas at the bottom thereof.

5.   An apparatus as claimed in claim 4 comprising gas distribution means at the said opening.

6.   An apparatus as claimed in claim 5 wherein the said gas distribution means comprise a porous frit (32).

7.   An apparatus as claimed in any of claims 1 to 6 wherein the said reaction chamber is a chemical vapour deposition reaction chamber.

8.   An apparatus as claimed in any of claims 1 to 7 which is paired and is adapted continuously to supply pnictide vapour species while the pair of the said reservoirs are alternately refilled with pnictide.

9. A process for the supply of a pnictide vapour species to a film deposition process characterised in that it comprises passing an inert gas through a reservoir of heated pnictide.

10. A process as claimed in claim 9 comprising depositing the pnictide vapour species carried by the inert gas on a substrate in a chemical vapour deposition process.

11. A process as claimed in claim 9 to claim 10 wherein the pnictide is maintained at a temperature below its boiling point.

12. A process as claimed in any of claims 9 to 11 wherein the inert gas is passed through the pnictide at a pressure of from 0.1 to 2.0 atmospheres (from $1.01 \times 10^4$ to $2.02 \times 10^5$ Pa).

13. A process as claimed in any of claims 9 to 12 wherein the $Pnictide_4$ inert gas is produced at a pressure of from 0.1 to 1.0 atmospheres (from $1.01 \times 10^4$ to $1.01 \times 10^5$ Pa).

14. A process as claimed in any of claims 9 to 13 wherein the pnictide is phosphorus.

0152669

# FIG.I

FIG.2